# EUROPEAN PATENT APPLICATION

(11) **EP 4 553 578 A1**
(43) Date of publication of application: **14.05.2025**
(21) Application number: 23835210.8
(22) Date of filing: 07.06.2023
(51) Int. Cl.: G03F 7/11, B41C 1/00, G03F 7/00

(54) **FILM FOR MANUFACTURING FLEXOGRAPHIC PRINTING PLATE, LAMINATE, AND METHOD FOR MANUFACTURING FLEXOGRAPHIC PRINTING PLATE**

(30) Priority: 05.07.2022 JP 2022108488
(71) Applicant: Asahi Kasei Kabushiki Kaisha, Tokyo 1000006 (JP)
(72) Inventor: ISHII, Takumi, Tokyo 100-0006 (JP); AKIYAMA, Hiroki, Tokyo 100-0006 (JP); MIYAMOTO, Shinji, Tokyo 100-0006 (JP)
(74) Representative: Strehl & Partner mbB
(86) International application number: PCT/JP2023/021251
(87) International publication number: WO 2024/009674

(57) **Abstract**

A film for flexographic printing plate production, comprising:
a base material; and
an ablation layer stacked on the base material, wherein
the ablation layer contains a resin having a constituent unit (1) represented by the following general formula (1), and
the base material has a thickness of 10 µm or more and less than 100 µm: 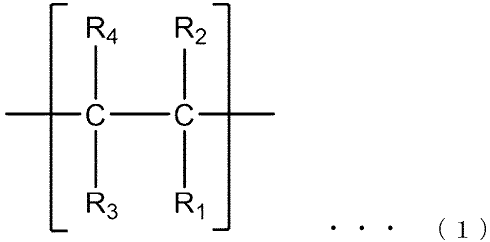 wherein, in the formula (1), R₁ and R₂ each independently represent a non-polar group, and R₃ and R₄ each independently represent a hydrogen atom or a non-polar group.

## Description

### Technical Field

The present invention relates to a film for flexographic printing plate production, a stack, and a method for producing a flexographic printing plate.

### Background Art

In recent years, flexographic printing by flexographic printing plates has been widely used as a method for printing soft package materials such as paper and films.

A method for producing a flexographic printing plate includes, for example, the following method.

First, for an original flexographic printing plate having a photosensitive resin composition layer on a support, the photosensitive resin composition layer is subjected to ultraviolet exposure (back exposure) from the support side to establish a uniform photocured layer.

Next, relief exposure is performed from the back side, i.e., the uncured surface side of the photosensitive resin composition layer which is the side opposite to the ultraviolet exposed surface. Examples of a method for the relief exposure include a method of performing ultraviolet exposure via a transparent image carrier (mask), such as a negative film, which permits selective transmission of an ultraviolet ray, and a method of performing ultraviolet exposure via a thin layer with an ultraviolet transmitting portion formed by infrared laser ablation based on an image as digital information.

The photosensitive resin composition of the unexposed portion of the original flexographic printing plate is removed for development by washing, for example, so that a relief image is formed to obtain a flexographic printing plate.

In the development of photosensitive resin compositions, a water development scheme, which does not use organic solvents, and a heat development scheme, which does not use a developing solution, have been studied with growing environmental consciousness in recent years. However, in both of these schemes, the photosensitive resin composition in the unexposed portion is supposed to be removed and then discarded in the developing step, posing the problem that there is still room for improvement in terms of reducing the burden on the environment.

As an improvement method from the viewpoint of reducing the burden on the environment, a method for producing a flexographic printing plate using a liquid photosensitive resin composition is proposed, in which the photosensitive resin composition in the unexposed portion is recovered and recycled for production of a flexographic printing plate (see, for example, Patent Literature 1). The method for producing a flexographic printing plate described in Patent Literature 1 is prevalent as a method for producing a flexographic printing plate with high environmental adaptability since it can achieve both a reduction in the amount of the photosensitive resin composition in the unexposed portion to be discarded and a reduction in production costs for the flexographic printing plate. On the other hand, in such a method for producing a flexographic printing plate, it is important to recover the photosensitive resin composition in the unexposed portion in a state comparable to the unused state.

In recent years, the CTP (Computer To Plate) technique has also become known with regard to the method for producing a flexographic printing plate.

In the CTP technique, an ablation layer that can be ablated by an infrared ray is established on top of the photosensitive resin composition layer, and the ablation layer is removed in a desired shape by irradiating it with an infrared laser to form an active ray transmitting portion that corresponds to a negative. Next, the photosensitive resin composition layer is irradiated with an ultraviolet ray using the ablation layer as a mask to allow the photosensitive resin composition to react in the same shape as the transmitting portion formed in the ablation layer and to undergo relief exposure, and finally, the ablation layer and the unexposed portion of the photosensitive resin composition that are no longer needed are developed and removed to produce a flexographic printing plate.

However, in the method for producing a flexographic printing plate as described above, there is a problem that it is difficult to isolate and recover the photosensitive resin composition in the unexposed portion after the relief exposure since the ablation layer and the photosensitive resin composition are designed to have high adhesion from the viewpoint of ensuring practicality. In addition, elution and migration of the ablation layer to the photosensitive resin composition cannot be fully suppressed, posing the problem that not only is it difficult to isolate and recover the unexposed portion, but also there is room for improvement in terms of ensuring the quality of the flexographic printing plate.

Here, "elution" refers to the components constituting the ablation layer being individually mixed into the photosensitive resin composition, and "migration" refers to the ablation layer being peeled off from the base material while maintaining its film shape and mixed into the photosensitive resin composition.

As a countermeasure to the above-described problems, there is proposed a method in which an image mask is formed by irradiating with an infrared laser an original flexographic printing plate having a photosensitive resin composition layer, a film layer, and an optical density varying layer corresponding to an ablation layer on a predetermined support (see, for example, Patent Literature 2).

In this method, the whole surface is exposed to an ultraviolet ray from above the image mask, then the image mask is peeled off and removed together with the film layer, and then development is further performed to obtain a flexographic printing plate. This method has the advantage that the optical density varying layer corresponding to the ablation layer is removed before the development, and thus elution and migration to the photosensitive resin composition layer can be suppressed.

However, there is a problem that if the film layer between the photosensitive resin composition layer and the optical density varying layer has a large film thickness, refraction and scattering of the ultraviolet ray are more likely to occur, resulting in reduced image reproducibility.

As a technique to prevent the reduction in image reproducibility as described above and to prevent elution and migration of the ablation layer to the photosensitive resin composition layer, there is proposed a method for producing a flexographic printing plate in which pattern exposure is performed using a layer cross-linked with a curable resin as a water-insoluble thermosensitive mask layer stacked on top of the photosensitive resin composition layer (see, for example, Patent Literature 3).

### Citation List

### Patent Literature

Patent Literature 1: Japanese Patent No. 5996197
Patent Literature 2: International Publication No. WO 2001/18605
Patent Literature 3: Japanese Patent No. 4442187

### Summary of Invention

### Technical Problem

However, the method for producing a flexographic printing plate proposed in Patent Literature 3 has the problem that if a predetermined adhesion adjusting layer is not established between the photosensitive resin composition layer and the thermosensitive mask layer, the adhesive force between the photosensitive resin composition layer and the thermosensitive mask layer becomes excessive, and elution and migration between the layers cannot be avoided. There is also a problem that damage to the finally obtained flexographic printing plate and thermal deterioration of the unexposed portion may occur since a heating treatment is required in stacking the thermosensitive mask layer on the photosensitive resin composition layer.

In view of the above-described problems of the conventional techniques, an object of the present invention is to provide a film for flexographic printing plate production that suppresses elution and migration of the ablation layer to the photosensitive resin composition layer and enables production of a flexographic printing plate with excellent image reproducibility, and a method for producing a flexographic printing plate using the same.

### Solution to Problem

The present inventors have conducted diligent studies in order to solve the problems and have found that the above-described problems can be solved by a film having an infrared ray ablation layer and a base material of a specific configuration, and thereby completed the present invention.

That is, the present invention is as follows.
[1] A film for flexographic printing plate production, comprising:
   a base material; and
   an ablation layer stacked on the base material, wherein
   the ablation layer contains a resin having a constituent unit (1) represented by the following general formula (1), and
   the base material has a thickness of 10 µm or more and less than 100 µm: 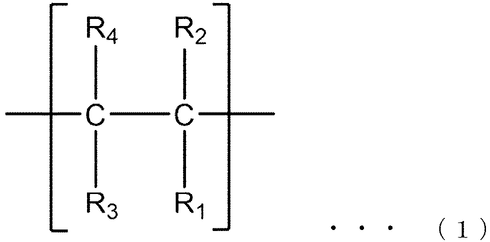
   wherein, in the formula (1), R₁ and R₂ each independently represent a non-polar group, and R₃ and R₄ each independently represent a hydrogen atom or a non-polar group.
[2] The film for flexographic printing plate production according to [1], wherein
   in the formula (1), R₁ and R₂ are each independently any one selected from the group consisting of an alkyl group, an alkenyl group, and an alkynyl group, and
   R₃ and R₄ are each independently any one selected from the group consisting of a hydrogen atom, an alkyl group, an alkenyl group, and an alkynyl group.
[3] The film for flexographic printing plate production according to [1] or [2], wherein
   in the formula (1), R₁ and R₂ are each independently an alkyl group, and
   R₃ and R₄ are each independently a hydrogen atom or an alkyl group.
[4] The film for flexographic printing plate production according to any one of [1] to [3], wherein
   the resin further contains a constituent unit (2) derived from a monovinyl-substituted aromatic hydrocarbon.
[5] The film for flexographic printing plate production according to any one of [1] to [4], wherein
   the base material contains a resin having a polyester or polyolefin skeleton.
[6] The film for flexographic printing plate production according to any one of [1] to [5], wherein
   the base material is made of a resin having a polyester or polyolefin skeleton.
[7] The film for flexographic printing plate production according to any one of [1] to [6], wherein
   the base material is made of a resin having a polyolefin skeleton.
[8] A stack comprising:
   an original flexographic printing plate having a photosensitive resin composition layer; and
   the film for flexographic printing plate production according to any one of [1] to [7] on the original flexographic printing plate.
[9] A method for producing a flexographic printing plate using the stack according to [8], comprising:
   a drawing step of irradiating the film for flexographic printing plate production according to any one of [1] to [7] with an infrared ray to draw and process a pattern;
   an exposure step of irradiating the photosensitive resin composition layer with an ultraviolet ray to form a pattern using, as a mask, the ablation layer on which the pattern has been drawn and processed in the drawing step; and
   a developing step of removing an unexposed portion of the photosensitive resin composition layer.
[10] The method for producing a flexographic printing plate according to [9], wherein
   the photosensitive resin composition contains a polymer having a carbonyl group.
[11] The method for producing a flexographic printing plate according to [9] or [10], wherein
   the base material of the film for flexographic printing plate production is made of a resin having a polyester or polyolefin skeleton.
[12] The method for producing a flexographic printing plate according to any one of [9] to [11], wherein the base material of the film for flexographic printing plate production is made of a resin having a polyolefin skeleton.
[13] The method for producing a flexographic printing plate according to any one of [9] to [12], further comprising: a recovery step of recovering the unexposed portion removed in the developing step, for use in production of a new original flexographic printing plate.

### Advantageous Effects of Invention

The present invention can provide a film for flexographic printing plate production that can suppress elution and migration of the ablation layer to the photosensitive resin composition layer and can produce a flexographic printing plate with excellent image reproducibility, a stack, and a method for producing a flexographic printing plate using the same.

### Brief Description of Drawings

[Figure 1] Figure 1 shows a schematic cross-sectional view of the film for flexographic printing plate production of the present invention.
[Figure 2] Figure 2 shows a schematic diagram of a method for producing a flexographic printing plate using the film for flexographic printing plate production of the present invention.

### Description of Embodiments

Hereinafter, an embodiment for carrying out the present invention (hereinafter, referred to as "present embodiment") will be described in detail.

The present embodiment given below is an illustration for describing the present invention and does not intend to limit the present invention to the contents given below.

The present invention can be carried out through appropriate changes or modifications without departing from the spirit of the present invention.

### [Film for Flexographic Printing Plate Production]

The film for flexographic printing plate production according to the present embodiment comprises:
a base material; and an ablation layer stacked on the base material, wherein the ablation layer contains a resin having a constituent unit (1) represented by the following general formula (1), and the base material has a thickness of 10 µm or more and less than 100 µm.

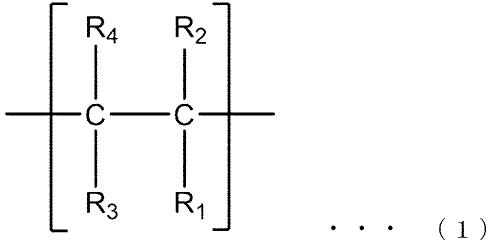

In the formula (1), R₁ and R₂ each independently represent a non-polar group, and R₃ and R₄ each independently represent a hydrogen atom or a non-polar group.

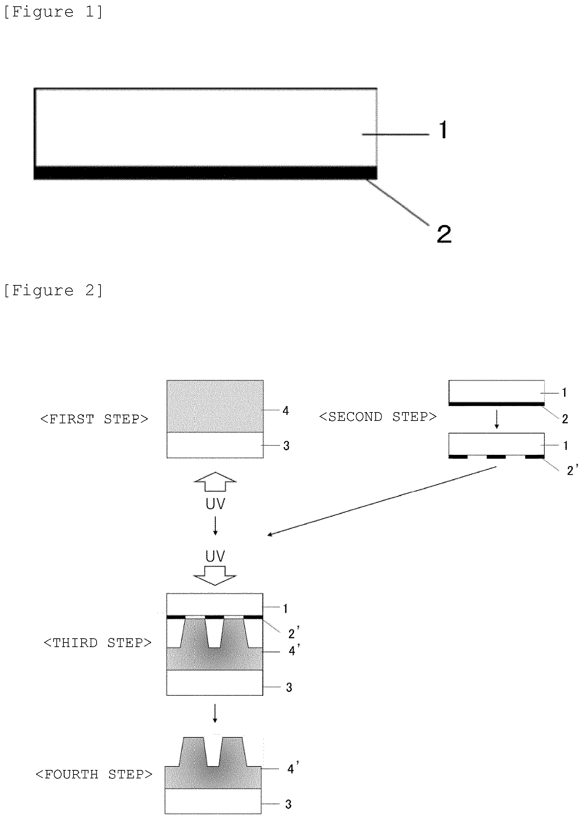

Figure 1 shows a schematic cross-sectional view of the film for flexographic printing plate production according to the present embodiment.

In the film for flexographic printing plate production according to the present embodiment, a base material 1 and an ablation layer 2, which functions as a mask when forming the target concavo-convex pattern of a flexographic printing plate, are stacked.

Hereinafter, the film for flexographic printing plate production according to the present embodiment will be described in detail.

### (Base Material)

The film for flexographic printing plate production according to the present embodiment has the base material 1 and the ablation layer 2 stacked on the base material 1. The ablation layer 2 is image-drawn and thus serves as a negative film for forming a relief in the production step of a flexographic printing plate as described later.

The quality, especially image reproducibility, of the relief is greatly affected by the negative film through which ultraviolet light transmits during the relief exposure. In general, the larger the thickness of the negative film, the greater the refraction and scattering of ultraviolet light in the negative film, and the lower the image reproducibility tends to be. Since the thickness of the base material 1 shown in Figure 1 accounts for the majority of the overall thickness of the negative film, a smaller thickness of the base material 1 is preferable from the viewpoint of flexographic printing plate quality.

On the other hand, it is also important for the negative film to have a certain degree of rigidity and dimensional stability. If the negative film is easily deformed, it tends to induce deformation and damage to the image formed on the negative film in the step before the relief exposure, resulting in reduced image reproducibility. However, if the rigidity of the negative film is too high, it tends to cause incompatibility with the apparatus in the production step of the target flexographic printing plate, or excessive stress concentration on the ablation layer during handling, causing irreversible damage such as scratches and wrinkles.

From the above-described viewpoints, the base material 1 shall have a thickness of 10 µm or more and less than 100 µm. The above numerical value range gives a film for flexographic printing plate production with excellent image reproducibility and moderate rigidity. Furthermore, the thickness is preferably 20 µm or more, and more preferably 40 µm or more. When the base material 1 has a thickness of 10 µm or more, sufficient strength and rigidity for practical use can be obtained, and deformation and damage to the image can be suppressed during the production step of a flexographic printing plate. In addition, from the viewpoint of ensuring moderate flexibility and providing good handleability in the production step of a flexographic printing plate, the thickness of the base material 1 shall be less than 100 µm, preferably 90 µm or less, and more preferably 70 µm or less.

The base material 1 preferably contains a resin having a polyester or polyolefin skeleton from the viewpoints of dimensional stability, transparency, and adhesion with the ablation layer 2. Here, the resin contained in the base material 1 may be a mixture of resins having polyester and polyolefin skeletons, or it may be a copolymer.

Examples of the polyester include, but are not limited to, polyethylene terephthalate, polybutylene terephthalate, and polyethylene naphthalate.

Examples of the resin having a polyolefin skeleton include, but are not limited to, polyethylene, polypropylene, and a resin in which they are copolymerized.

In addition, from the viewpoint of image reproducibility, the base material 1 is more preferably made of a resin having a polyester or polyolefin skeleton, and further preferably made of a resin having a polyolefin skeleton. This is because the resin having a polyolefin skeleton has a high oxygen permeability. Here, the oxygen permeability is one of the physical property values of the film, and represents the amount of oxygen that passes through per 1 m² of film in one day under the condition of 1 atm (1 atmospheric pressure). The unit is cm³/m²·24 h·atm, where a larger value indicates easier passage and a smaller value indicates harder passage.

In the production step of a flexographic printing plate, when the photosensitive resin composition layer is cured by ultraviolet ray irradiation, the curing proceeds by radical polymerization. If oxygen coexists during this radical polymerization, the polymerization reaction is inhibited by the reaction between the radical-producing compound and oxygen. That is, by reducing the amount of oxygen coexisting during exposure of the photosensitive resin composition layer, the degree of polymerization can be increased, and the image reproducibility of the final flexographic printing plate can be enhanced. Here, if the base material 1 of the film for flexographic printing plate production according to the present embodiment stacked on the photosensitive resin composition has a high oxygen permeability, the oxygen remaining on the surface and/or inside of the photosensitive resin composition layer during ultraviolet ray irradiation can easily diffuse to the outside, and the effect of inhibition of polymerization reaction by oxygen can be suppressed.

In the film for flexographic printing plate production according to the present embodiment, the base material may be used in an untreated state. However, it may be subjected to a predetermined surface treatment as necessary, or one that has been given a function such as antistatic treatment may be used. Examples of the surface treatment include a corona treatment and a matte processing.

### (Ablation Layer)

In the film for flexographic printing plate production according to the present embodiment, as shown in Figure 1, the ablation layer 2 is stacked on top of the base material 1.

The ablation layer 2 contains a predetermined resin, is ablatable by an infrared laser, and also has the function as a shielding layer for rays other than infrared ray.

In order to suppress elution of components contained in the ablation layer 2 to the photosensitive resin composition layer and migration of the ablation layer 2 to the photosensitive resin composition, it is preferable to improve the adhesion between the base material 1 and the ablation layer 2 or to decrease the miscibility of the ablation layer 2 with the photosensitive resin composition layer.

The components contained in the ablation layer 2 refer to a resin, an infrared ray absorbing substance, a shielding substance, and others.

From the viewpoint of improving the adhesion between the base material 1 and the ablation layer 2, it is important to strengthen the interaction between the layers. Examples of such a method for strengthening the interaction between the layers include a method in which similar molecular structures are given to the constituent materials of both the base material 1 and the ablation layer 2 to improve the chemical interaction, and a method in which the physical interaction is improved. Examples of the method for improving the physical interaction include a method in which the flexibility of the ablation layer 2 is improved or moderate flexibility is given in order to suppress peeling at the time of film bending. Meanwhile, a method in which high ablation efficiency with an infrared laser is ensured while maintaining the adhesion between the layers is also effective.

From the above-described viewpoints, the film for flexographic printing plate production according to the present embodiment shall be such that the ablation layer 2 contains a resin having a constituent unit (1) represented by the following general formula (1), which contains a quaternary carbon atom to which two non-polar groups are bonded.

The resin may have other constituent units as necessary.

In the present specification, "monomer" means a compound before polymerization, and "constituent unit" means a predetermined repeat unit constituted by the polymerization of a monomer.

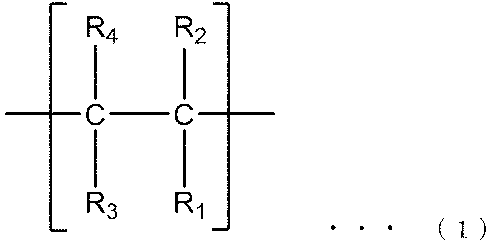

In the formula (1), R₁ and R₂ each independently represent a non-polar group, and R₃ and R₄ each independently represent a hydrogen atom or a non-polar group.

### <Resin Having Constituent Unit (1) Represented by General Formula (1)>

As described above, the ablation layer 2 in the film for flexographic printing plate production according to the present embodiment contains a resin having a constituent unit (1) represented by the general formula (1).

In the case where the resin contained in the ablation layer 2 has polar groups in the main chain, the strength of the ablation layer 2 is improved due to the strong formation of non-covalent bonds between molecules. Meanwhile, the structure used to interact with the constituent starting materials of the base material 1 is reduced, and the adhesion between the base material 1 and the ablation layer 2 tends to decrease. In addition, the rigidity of the ablation layer 2 tends to become too high, and the stress caused by bending and stretching tends to concentrate between the layers, which can easily lead to interfacial peeling.

Furthermore, in the case where the resin contained in the ablation layer 2 has polar groups in side chains, it tends to be not preferable from the viewpoint of ablation efficiency of the ablation layer 2 with a laser, as will be described below.

To ensure ablation efficiency with a laser, it is important that the resin contained in the ablation layer 2 is easily depolymerized. "Depolymerization" refers to the reverse reaction of the polymerization reaction, in which the polymer is decomposed into monomers.

The irradiation with an infrared laser causes the ablation layer 2 to instantaneously reach a high temperature of several hundred degrees Celsius. At that time, decomposition of the main chains in the resin occurs, resulting in a rapid drop in molecular weight, which is removed from the ablation layer 2. However, in the case of a resin that is not easily depolymerized, only degradation of side chains occurs during ablation, and no cleavage of the main chain occurs. Therefore, the resin remains in the ablation layer 2 even after the irradiation with an infrared laser. Resins obtained by condensation polymerization are known to form a ring structure at the time of decomposition, followed by cleavage of the main chain. That is, a drop in molecular weight does not occur easily with infrared ray ablation, which is a heat treatment for a short time, and an ablation layer containing a resin obtained by such condensation polymerization tends to have poor ablation efficiency.

From the above-described viewpoints, it is important that the ablation layer 2 contains a resin that is easily depolymerized. In general, it is known that cleavage of the main chain is likely to start from thermally unstable portions present in the polymer such as branches. However, if side chains corresponding to branches have polarity at this time, decomposition of the side chains is likely to occur dominantly, which is not preferable because it is difficult for cleavage of the main chain to occur.

Therefore, it is important that side chains of the resin contained in the ablation layer 2 in the film for flexographic printing plate production according to the present embodiment are non-polar groups. Also, when cleavage of the main chain proceeds, the contribution of intramolecular or intermolecular chain transfer cannot be neglected. Therefore, it is preferable to have no tertiary hydrogen, which is easily abstracted by chain transfer. In other words, it is important that the portion corresponding to the symmetry plane of the branch is also a non-polar group.

It is also important that the side chains are non-polar groups from the viewpoint of acquiring rubber-like elasticity. This provides a soft part in the elastomer and improves the flexibility of the ablation layer 2.

From the above-described viewpoints, in the film for flexographic printing plate production according to the present embodiment, the content of the resin having a constituent unit (1) represented by the general formula (1) in the ablation layer is preferably 20% by mass or more, more preferably 30% by mass or more, and further preferably 40% by mass or more.

The non-polar groups in the above general formula (1) are preferably any of the following: an alkyl group, an aryl group, a cycloalkyl group, a phenyl group, an alkenyl group, an aralkyl group, a cycloalkenyl group, an alkynyl group, a silyl group, and a siloxanyl group. The non-polar groups do not include a hydrogen atom.

In particular, from the viewpoint of improving the flexibility of the ablation layer 2 and ensuring the adhesion with the base material 1, in the general formula (1), it is more preferable that R₁ and R₂ are each independently any one selected from the group consisting of an alkyl group, an alkenyl group, and an alkynyl group, and in terms of having low polarity, it is further preferable that they are alkyl groups.

Examples of the monomer capable of forming a constituent unit represented by the general formula (1) include, but are not limited to, isobutylene, 2-methyl-2-butene, 2,3-dimethyl-2-butene, and those in which a methyl group of these is replaced by another alkyl group such as ethyl group, and modified products thereof; α-methylstyrene, cis-(1-methyl-1-propenyl)benzene, trans-(1-methyl-1-propenyl)benzene, and those in which a methyl group of these is replaced by another alkyl group such as ethyl group, and their modified products; and 1,1-diphenylethylene.

In the general formula (1), R₃ and R₄ each independently represent a hydrogen atom or a non-polar group.

It is preferable that R₃ and R₄ are each independently any one selected from the group consisting of a hydrogen atom, an alkyl group, an alkenyl group, and an alkynyl group, and it is more preferable that they are each independently a hydrogen atom or an alkyl group. It is further preferable that R₃ and R₄ are both hydrogen atoms, as the depolymerizability of the resin is further improved.

The constituent unit (1) represented by the general formula (1) constituting the resin may be of one type alone or of two or more types. For example, the resin may have, as the constituent unit (1), a constituent unit in which R₁ and R₂ are alkyl groups, and a constituent unit in which one of R₁ and R₂ is an alkyl group and the other is a phenyl group. By having both an alkyl group and a phenyl group, the characteristics of the both groups can be obtained.

It is preferable that the above-described resin contained in the ablation layer 2 further contain, in addition to the constituent unit (1), a constituent unit (2) derived from a monovinyl-substituted aromatic hydrocarbon.

The monovinyl aromatic hydrocarbon may be chemically bonded to the constituent unit (1) represented by the general formula (1), or may be added as a separate resin, but from the viewpoints of dispersibility and resulting laser processing uniformity, it is preferable that the constituent unit (2) derived from the monovinyl-substituted aromatic hydrocarbon is chemically bonded to the constituent unit (1) represented by the general formula (1), forming a copolymer.

When the resin used for the ablation layer contains a constituent unit (2) derived from a monovinyl-substituted aromatic hydrocarbon, the adhesion between the ablation layer 2 and the base material 1 tends to be improved and the rigidity of the film for flexographic printing plate production according to the present embodiment also tends to be improved.

Examples of the compound used for forming the constituent unit (2) derived from the monovinyl aromatic hydrocarbon include, but are not limited to, monomers such as styrene, t-butylstyrene, N,N-dimethyl-p-aminoethylstyrene, N,N-diethyl-p-aminoethylstyrene, vinylpyridine, p-methylstyrene, and tert-butylstyrene. In particular, styrene is preferable from the viewpoint of being able to smoothly mold the film for flexographic printing plate production according to the present embodiment at a relatively low temperature.

The constituent unit (2) may be of only one type alone or of two or more types.

### <Infrared Ray Absorbing Substance>

The ablation layer 2 may contain an infrared ray absorbing substance to perform ablation processing. Examples of the infrared ray absorbing substance include a simple substance or compound that has strong absorption, usually in the range of 750 to 2000 nm.

Examples of the infrared ray absorbing substance include, but are not limited to, an inorganic pigment such as carbon black, graphite, copper chromite, and chromium oxide; and a dye such as polyphthalocyanine compound, cyanine dye, and metal thiolate dye. The smaller the particle size, the higher the sensitivity to the infrared laser. In particular, carbon black can be used with a particle size in the wide range of 13 to 85 nm, and is preferable as the infrared ray absorbing substance. Carbon black can also function as the shielding substance, as will be described below. These infrared ray absorbing substances are added to the extent that they provide sensitivity capable of being ablated by the laser beam used.

### <Shielding Substance>

The ablation layer 2 may contain a shielding substance for non-infrared rays such as ultraviolet ray in order to serve as a mask. As the shielding substance for non-infrared rays, a substance that reflects or absorbs ultraviolet light can be used.

Examples of the shielding substance include, but are not limited to, an ultraviolet ray absorber, carbon black, and graphite.

### <Film Thickness of Ablation Layer>

The ablation layer 2 in the film for flexographic printing plate production according to the present embodiment should have a larger film thickness from the viewpoint of ensuring shielding against an ultraviolet ray during the exposure step described below, and should have a thinner film thickness from the viewpoint of increasing ablatability.

From the above viewpoints, the film thickness of the ablation layer 2 is preferably 0.1 µm or more and 20 µm or less, more preferably 0.5 µm or more and 15 µm or less, and further preferably 1.0 µm or more and 10 µm or less.

For the non-infrared ray shielding effect of the ablation layer 2, the ablation layer 2 preferably has an optical density of 2 or more, and more preferably has an optical density of 3 or more.

The optical density can be measured using the D200-II transmission densitometer (manufactured by GretagMacbeth LLC). In addition, the optical density is the so-called visual density (ISO visual), and the light to be measured is in the wavelength range of about 400 to 750 nm.

### [Method for Producing Film for Flexographic Printing Plate Production]

Examples of the method for producing a film for flexographic printing plate production according to the present embodiment include, but are not limited to, the following method: for example, in the case of using carbon black as both the infrared ray absorbing substance and the shielding substance for non-infrared rays, at first, a solution of a resin having a constituent unit (1) represented by the general formula (1) described above is prepared using a predetermined solvent, carbon black and a dispersing agent are added thereto, and carbon black is dispersed in the resin solution to thereby obtain a solution or dispersion for ablation layer 2 film formation. Thereafter, a predetermined base material 1 is coated with the solution or dispersion for ablation layer film formation to thereby producing a film for flexographic printing plate production.

As the method for dispersing carbon black in the resin solution, a method of using forced stirring with a stirring blade in combination with stirring utilizing ultrasonic waves or various types of mills is effective. Alternatively, the resin, carbon black, and the dispersing agent are preliminary kneaded using an extruder or kneader and then dissolved in the solvent, which is also an effective method for obtaining good dispersibility of carbon black. Another example is a method in which carbon black is forcibly dispersed in the resin in the state of a latex dispersion.

The solvent used to prepare the solution or dispersion for ablation layer 2 film formation can be selected as appropriate, taking into consideration the solubility of the resin and infrared ray absorber to be used. Only one type of solvent may be used, or a mixture of two or more solvents may be used.

Also, the film quality of the ablation layer 2 can be improved by mixing a solvent with a relatively low boiling point and a solvent with a high boiling point to control the volatilization rate of the solvent, for example.

Examples of the solvent for ablation layer 2 film formation include, but are not limited to, toluene, xylene, cyclohexane, methyl acetate, ethyl acetate, propyl acetate, butyl acetate, amyl acetate, methyl ethyl ketone, acetone, cyclohexanone, ethylene glycol, propylene glycol, ethanol, water, propylene glycol monomethyl ether, propylene glycol monomethyl ether acetate, dimethylacetamide, dimethylformamide, n-propyl alcohol, i-propyl alcohol, 1,4-dioxane, tetrahydrofuran, diethyl ether, n-hexane, n-heptane, n-pentane, acetonitrile, and analogues thereof.

### [Stack]

The stack according to the present embodiment has a configuration in which an original flexographic printing plate having a photosensitive resin composition layer and the above-described film for flexographic printing plate production according to the present embodiment on the original flexographic printing plate are stacked.

The original flexographic printing plate has a support and a photosensitive resin composition layer stacked on the support.

As will be described later, relief formation is performed on the original flexographic printing plate by pattern exposure, and the unexposed portion is developed and removed to thereby obtain the target flexographic printing plate.

### (Support)

Examples of the support of original printing plate include, but are not limited to, a polyester film, a polyamide film, a polyacrylonitrile film, and a polyvinyl chloride film.

Among these, the support is preferably a polyester film.

Examples of the polyester used for the support include, but are not limited to, polyethylene terephthalate, polybutylene terephthalate, and polyethylene naphthalate.

The thickness of the support is not particularly limited, but is preferably 50 to 300 µm.

A predetermined adhesive layer may be provided on the support in order to enhance the adhesive force between the support and the photosensitive resin composition layer which will be described later. Examples of the adhesive layer include, but are not particularly limited to, the adhesive layer described in International Publication No. WO 2004/104701, Japanese Patent No. 3094647, and Japanese Patent No. 2634429.

### (Photosensitive Resin Composition Layer)

The original printing plate has a photosensitive resin composition layer on the support.

The photosensitive resin composition layer may be stacked directly on the support, or may be indirectly stacked via a predetermined adhesive layer or the like.

The photosensitive resin composition layer is preferably in a form containing, for example, the polymer (b-1), ethylenically unsaturated compound (b-2), and photopolymerization initiator (b-3) described later. They can be used selectively as appropriate.

The photosensitive resin composition layer may further contain an auxiliary additive component, if necessary.

Hereinafter, each component of the photosensitive resin composition layer will be described in detail.

### <Polymer (b-1)>

The polymer (b-1) may be a linear, branched, or dendritic polymer, and may be a homopolymer or a copolymer. The copolymer may be a random copolymer, an alternating copolymer, or a block copolymer.

Examples of the polymer (b-1) include a polymer conventionally used in the production of flexographic printing plates, such as completely or partially hydrolyzed polyvinyl ester, partially hydrolyzed polyvinyl acetate, a polyvinyl alcohol derivative, a partially hydrolyzed vinyl acetate/alkylene oxide graft copolymer, or polyvinyl alcohol subsequently acylated by polymer-analogous reaction, polybutadiene, polyamide, and mixtures thereof.

In addition to those described above, a thermoplastic elastomer block copolymer can also be used, for example.

Examples of the thermoplastic elastomer block copolymer include a copolymer containing at least one block containing an alkenyl aromatic monomer unit and at least one block containing a 1,3-diene monomer unit. Examples of the alkenyl aromatic compound that forms the alkenyl aromatic monomer unit include styrene, α-methylstyrene, and vinyltoluene. As 1,3-diene, for example, butadiene and isoprene are preferable from the viewpoint of reducing the steric hindrance of a vinyl group, enhancing photo-cross-linking efficiency, and preventing elution of the ablation layer to the original printing plate after exposure.

Furthermore, the polymer (b-1) preferably includes a compound having a carbonyl group. The use of a compound having a carbonyl group with high polarity as the polymer (b-1) tends to be able to decrease the miscibility with the resin having non-polar groups in the ablation layer, so that elution of the ablation layer to the photosensitive resin composition layer can be suppressed.

Examples of the polymer (b-1) include, but are not limited to, polyester, polyamide, and polyurethane. From the viewpoint of preventing damage to the relief surface due to the load when peeling off the film for flexographic printing plate production after the exposure step, the polymer (b-1) more preferably includes polyurethane. The polyurethane preferably has a (meth)acrylic group as a terminal group from the viewpoint of improving the mechanical physical properties of the finally obtained flexographic printing plate by photo-cross-linking.

Examples of a method for producing the polyurethane having a (meth)acrylic group as a terminal group include a method of reacting diol having a repeat unit in the molecule with diisocyanate to form polyurethane having a terminal isocyanate group with an arbitrary molecular weight, and subsequently reacting the polyurethane with a compound having active hydrogen and a (meth)acrylic group in one molecule for production. Another example thereof includes a method of reacting diol having a repeat unit in the molecule with diisocyanate to form polyurethane having a terminal isocyanate group with an arbitrary molecular weight, and subsequently reacting the polyurethane with a compound having a hydroxy group and a (meth)acrylic group in one molecule for production.

The polyurethane structure obtained by the production method described above is a structure constructed through the reaction of diol having a repeat unit in the molecule with diisocyanate.

Hereinafter, the "polyurethane having a (meth)acrylic group as a terminal group" produced by the method described above is referred to as an "unsaturated prepolymer".

Examples of the "diol having a repeat unit in the molecule" for use in the production of the unsaturated prepolymer include, but are not limited to, polyester diol consisting of dicarboxylic acid and diol; polyether diol; polyether/polyester copolymer diol; and a 1,2-polybutadiene compound having a terminal hydroxy group. The diol having a repeat unit in the molecule may be used singly or may be used in combinations of two or more thereof.

Examples of the dicarboxylic acid constituting the polyester diol include, but are not limited to, succinic acid, glutaric acid, adipic acid, pimelic acid, suberic acid, azelaic acid, sebacic acid, maleic acid, terephthalic acid, isophthalic acid and 1,5-naphthalenedicarboxylic acid.

Examples of the diol constituting the polyester diol include, but are not limited to, 1,4-butanediol, 2-methyl-1,3-propanediol, 3-methyl-1,5-pentanediol, neopentyldiol, 1,6-hexanediol, 1,9-nonanediol, 2-methyl-1,8-octanediol, and diethylene glycol (dioxyethylenediol).

Examples of the polyether diol include, but are not limited to, polyoxyethylenediol, polyoxypropylenediol, polyoxytetramethylenediol, polyoxy 1,2-butylenediol, polyoxyethylene/polyoxypropylene random copolymer diol, polyoxyethylene/polyoxypropylene block copolymer diol, polyoxyethylene/polyoxytetramethylene random copolymer diol, and polyoxyethylene/polyoxytetramethylene block copolymer diol.

Examples of the polyether/polyester copolymer diol include, but are not limited to, a copolymer having a structure where the repeat unit that forms the molecular chain of the above-described polyether diol and the repeat unit that forms the molecular chain of the above-described polyester diol are linked in a block or random pattern.

The 1,2-polybutadiene compound having a terminal hydroxy group may be a hydrogenated compound. Examples of the 1,2-polybutadiene compound having a terminal hydroxy group include, but are not limited to, poly-1-butene hydride and 1,2-polybutadiene hydride. The number of terminal hydroxy groups is not particularly limited and is preferably 1.2 or more, more preferably 1.5 or more, and further preferably 2.0 or less per molecule from the viewpoint of preventing damage to the relief surface due to the load when peeling off the film for printing plate production after exposure.

Examples of the diisocyanate include, but are not limited to, tolylene diisocyanate, xylylene diisocyanate, hexamethylene diisocyanate, trimethylhexamethylene diisocyanate, isophorone diisocyanate, diphenylmethane diisocyanate, cyclohexane diisocyanate, dicyclohexylmethane diisocyanate, and norbornene diisocyanate.

The diisocyanate may be used singly or in combinations of two or more thereof.

### <Ethylenically Unsaturated Compound (b-2)>

The photosensitive resin composition layer preferably contains an ethylenically unsaturated compound (b-2), as described above. The ethylenically unsaturated compound (b-2) is a compound having a radically polymerizable unsaturated double bond. Examples of the ethylenically unsaturated compound (b-2) include, but are not limited to, olefins such as ethylene, propylene, vinyltoluene, styrene, and divinylbenzene; acetylenes; (meth)acrylic acid and/or derivatives thereof; haloolefins; unsaturated nitriles such as acrylonitrile; unsaturated amides such as acrylamide or methacrylamide, and derivatives thereof; unsaturated dicarboxylic acids and derivatives thereof such as maleic anhydride, maleic acid, and fumaric acid; vinyl acetates; N-vinylpyrrolidone; N-vinylcarbazole; and N-substituted maleimide compounds.

Examples of each of the derivatives include, but are not limited to, an alicyclic compound having a cycloalkyl group, a bicycloalkyl group, a cycloalkenyl group, a bicycloalkenyl group, or the like; an aromatic compound having a benzyl group, a phenyl group, a phenoxy group, a naphthalene skeleton, an anthracene skeleton, a biphenyl skeleton, a phenanthrene skeleton, a fluorene skeleton, or the like; a compound having an alkyl group, a halogenated alkyl group, an alkoxyalkyl group, a hydroxyalkyl group, an aminoalkyl group, a glycidyl group, or the like; an ester compound with a polyhydric alcohol such as an alkylene glycol, a polyoxyalkylene glycol, a polyalkylene glycol, or trimethylolpropane; and a compound having a polysiloxane structure, such as polydimethylsiloxane and polydiethylsiloxane.

In addition, the ethylenically unsaturated compound (b-2) may be a heteroaromatic compound containing an element such as nitrogen or sulfur.

Examples of the (meth)acrylic acid and/or derivatives thereof include, but are not limited to, a diacrylate and a dimethacrylate of an alkanediol such as hexanediol or nonanediol; a diacrylate and a dimethacrylate of ethylene glycol, diethylene glycol, propylene glycol, dipropylene glycol, polyethylene glycol, or butylene glycol; trimethylolpropane tri(meth)acrylate; dimethylol tricyclodecane di(meth)acrylate; isobornyl (meth)acylate; phenoxy polyethylene glycol (meth)acrylate; and pentaerythrit tetra(meth)acrylate.

These may be used singly or in combinations of two or more thereof.

From the viewpoint of improving the strength of the original flexographic printing plate and preventing damage to the relief surface due to the load when peeling off the film for flexographic printing plate production according to the present embodiment after exposure, at least one (meth)acrylate is preferably used, and at least one bifunctional (meth)acrylate is more preferably used as the ethylenically unsaturated compound (b-2).

### <Photopolymerization Initiator (b-3)>

The photosensitive resin composition layer preferably contains a photopolymerization initiator (b-3).

The photopolymerization initiator (b-3) is a compound that absorbs the energy of light to produce a radical. Examples thereof include a degradable photopolymerization initiator, a hydrogen abstraction type photopolymerization initiator, and a compound having a site functioning as a hydrogen abstraction type photopolymerization initiator and a site functioning as a degradable photopolymerization initiator in the same molecule.

Examples of such a photopolymerization initiator (b-3) include, but are not limited to, benzophenones such as benzophenone, 4,4-bis(diethylamino)benzophenone, 3,3',4,4'-benzophenone tetracarboxylic anhydride, and 3,3',4,4'-tetramethoxy benzophenone; anthraquinones such as t-butyl anthraquinone and 2-ethyl anthraquinone; thioxanthones such as 2,4-diethyl thioxanthone, isopropyl thioxanthone, and 2,4-dichloro thioxanthone; Michler's ketone; acetophenones such as diethoxyacetophenone, 2,2-dimethoxy-2-phenylacetophenone, 2-hydroxy-2-methyl-1-phenylpropan-1-one, benzyl dimethyl ketal, 1-hydroxycyclohexyl-phenyl ketone, 2-methyl-2-morpholino(4-thiomethylphenyl)propan-1-one, 2-methyl-1-(4-methylthiophenyl)-2-morpholino-propan-1-one, 2-benzyl-2-dimethylamino-1-(4-morpholinophenyl)-butanone, and trichloroacetophenone; benzoin ethers such as benzoin methyl ether, benzoin ethyl ether, benzoin isopropyl ether, and benzoin isobutyl ether; acylphosphine oxides such as 2,4,6-trimethylbenzoyl diphenyl phosphine oxide, bis(2,6-dimethoxybenzoyl)-2,4,4-trimethyl pentyl phosphine oxide, and bis(2,4,6-trimethylbenzoyl)-phenyl phosphine oxide; methyl benzoylformate; 1,7-bisacridinyl heptane; 9-phenyl acridine; and azo compounds such as azobisisobutyronitrile, diazonium compounds, and tetrazene compounds.

These may be used singly or in combinations of two or more thereof.

The content of the photopolymerization initiator (b-3) in the photosensitive resin composition layer is preferably 0.1% by mass or more and 10% by mass or less, more preferably 0.1% by mass or more and 5% by mass or less, and further preferably 0.3% by mass or more and 5% by mass or less when the whole amount of the photosensitive resin composition layer is assumed to be 100% by mass from the viewpoint of preventing breakage of the finally obtained original flexographic printing plate and preventing damage to the relief surface due to the load when peeling off the film for printing plate production according to the present embodiment after exposure.

### <Auxiliary Additive Component>

The auxiliary additive component is not limited, and examples thereof include a plasticizer, a thermal polymerization inhibitor, an antioxidant, a light stabilizer, an ultraviolet ray absorber, and a dye or pigment.

Examples of the plasticizer include, but are not limited to, a liquid diene such as liquid polybutadiene, liquid polyisoprene, a modified product of liquid polybutadiene, a modified product of liquid polyisoprene, a liquid acrylonitrile-butadiene copolymer, and a liquid styrene-butadiene copolymer; a hydrocarbon oil such as naphthene oil and paraffin oil; a conjugated diene rubber mainly composed of a liquid diene, such as a liquid acrylonitrile-butadiene copolymer or a liquid styrene-butadiene copolymer; a polystyrene having a number average molecular weight of 2000 or less; and an ester-based plasticizer such as a sebacic acid ester or a phthalic acid ester.

These plasticizers may have a hydroxyl group or a carboxyl group. In addition, a photopolymerizable, reactive group such as a (meth)acryloyl group may be added thereto.

The plasticizers may be used singly, or two or more thereof may be used together.

In the present specification, "liquid" means a characteristic having the property of being easily flow-deformable and capable of being solidified into a deformed shape by cooling.

The content of the plasticizer in the photosensitive resin composition layer is preferably 0% by mass or more and 30% by mass or less, more preferably 8% by mass or more and 30% by mass or less, and further preferably 8% by mass or more and 25% by mass or less when the whole amount of the photosensitive resin composition layer is assumed to be 100% by mass from the viewpoint of improving the flexibility of the resulting original flexographic printing plate and preventing damage to the ablation layer when peeling off the film for printing plate production according to the present embodiment after exposure and elution to the photosensitive resin composition layer.

As the thermal polymerization inhibitor and the antioxidant, those usually used in the field of resin materials or rubber materials can be used. Specific examples thereof include a phenol-based material.

Examples of the phenol-based material as the thermal polymerization inhibitor and the antioxidant include, but are not limited to, vitamin E, tetrakis-(methylene-3-(3',5'-di-t-butyl-4'-hydroxyphenyl)propionate)methane, 2,5-di-t-butylhydroquinone, 2,6-di-t-butyl-p-cresol, 3,9-bis-{1,1-dimethyl-2-[3-(3-t-butyl-4-hydroxy-5-methylphenyl)propionyloxy]ethyl}-2,4,8,10-tetraoxaspiro(5,5)undecane, and 2-t-butyl-6-(3-t-butyl-2-hydroxy-5-methylbenzyl)-4-methylphenyl acrylate.

Other examples of the thermal polymerization inhibitor and the antioxidant include a phosphine-based material such as triphenyl phosphite.

The thermal polymerization inhibitor and the antioxidant may be used singly or in combinations of two or more thereof.

Examples of the light stabilizer and the ultraviolet ray absorber include, but are not limited to, known benzophenone-based, salicylate-based, acrylonitrile-based, metal complex-based, or hindered amine-based compounds.

The dye or pigment described below may also be used as the ultraviolet ray absorber.

Examples of such a light stabilizer and an ultraviolet ray absorber include, but are not limited to, 2-ethoxy-2'-ethyloxalic acid bisanilide, 2,2'-dihydroxy-4-methoxybenzophenone, bis(1,2,2,6,6-pentamethyl-4-piperidyl)-decanedioate, and 1,2,3-benzotriazole.

The dye or pigment is effective as coloring means for improving visibility.

Examples of the dye include, but are not limited to, a basic dye, an acid dye, and a direct dye, which are water-soluble, and a sulfur dye, an oil-soluble dye, and a disperse dye, which are non-water-soluble. Particularly, an anthraquinone-based dye, an indigoid-based dye, and an azo-based dye are preferable.

Examples of the pigment include, but are not particularly limited to, a natural pigment, a synthetic inorganic pigment, and a synthetic organic pigment. Examples of the synthetic organic pigment include an azo-based pigment, a triphenylmethane-based pigment, a quinoline-based pigment, an anthraquinone-based pigment, and a phthalocyanine-based pigment.

### [Method for Producing Flexographic Printing Plate]

Hereinafter, suitable forms will be given as to the method for producing a flexographic printing plate according to the present embodiment.

The method for producing a flexographic printing plate according to the present embodiment is not limited by the following forms.

In the method for producing a flexographic printing plate according to the present embodiment, the above-described stack according to the present embodiment is used.

As described above, the stack has a configuration in which an original flexographic printing plate having a photosensitive resin composition layer and the film for flexographic printing plate production according to the present embodiment are stacked.

The method for producing a flexographic printing plate according to the present embodiment includes: a drawing step of irradiating the film for flexographic printing plate production with an infrared ray to draw and process a pattern; an exposure step of irradiating the photosensitive resin composition layer with an ultraviolet ray to form a pattern using, as a mask, the ablation layer on which the pattern has been drawn and processed in the drawing step; and a developing step of removing an unexposed portion of the photosensitive resin composition layer.

In the printing pattern drawing step in the method for producing a flexographic printing plate according to the present embodiment, the target of infrared ray irradiation may be a film for flexographic printing plate production that constitutes the stack, or a film for flexographic printing plate production in the preliminary stage of constituting the stack.

That is, the film for flexographic printing plate production that constitutes the stack according to the present embodiment includes both of the forms before and after pattern drawing.

In more detail, the method for producing a flexographic printing plate according to the present embodiment includes: the step of first performing ultraviolet ray irradiation from the support side of the original flexographic printing plate that constitutes the stack according to the present embodiment (first step); the drawing step of drawing and processing a pattern on the ablation layer in the film for flexographic printing plate production by infrared ray irradiation (second step); the exposure step of irradiating the photosensitive resin composition layer with an ultraviolet ray to form a pattern using, as a mask, the ablation layer on which the pattern has been drawn and processed (third step); and the developing step of removing an unexposed portion of the photosensitive resin composition layer (fourth step).

If necessary, the step of performing a post-exposure treatment is then performed to obtain a flexographic printing plate formed from a cured photosensitive resin composition layer.

In the above-described method for producing a flexographic printing plate, the film for flexographic printing plate production that constitutes the stack in the second step is in the form before pattern drawing, and the film for flexographic printing plate production that constitutes the stack in the third step is in the form after pattern drawing.

From the viewpoint of conferring peeling properties, the surface of the flexographic printing plate may be brought into contact with a liquid containing a silicone compound and/or a fluorine compound.

Figure 2 shows a schematic diagram of a method for producing a flexographic printing plate using the film for flexographic printing plate production according to the present embodiment. Hereinafter, each step will be described in detail.

### (First Step)

In the first step, ultraviolet ray irradiation is performed to the photosensitive resin composition layer 4 from a side of the support 3 of flexographic original printing plate.

The ultraviolet ray irradiation method is not particularly limited, and can be carried out using a known irradiation unit. The wavelength of ultraviolet ray in the irradiation is preferably 150 to 500 nm, and more preferably 300 to 400 nm.

The light source of the ultraviolet ray is not limited, but, for example, a low-pressure mercury lamp, a high-pressure mercury lamp, an ultrahigh-pressure mercury lamp, a metal halide lamp, a xenon lamp, a zirconium lamp, a carbon arc lamp, and a fluorescent lamp for ultraviolet ray can be used.

This first step may be performed before or after the second step described later.

### (Second Step)

In the second step, the ablation layer 2 in the film for flexographic printing plate production is irradiated with an infrared ray to draw and process a pattern. The drawing and processing method is not particularly limited, and can be carried out using a known irradiation unit. The irradiation of infrared ray to the ablation layer 2 can be carried out from the ablation layer 2 side.

The ablation layer 2 is then pattern-irradiated with an infrared ray to decompose the resin of the irradiated part of the infrared ray, and the pattern is drawn and processed. This forms a mask of the ablation layer on the film for flexographic printing plate production. As a result, an ablation layer 2' on which the pattern has been drawn and processed is obtained.

Examples of the infrared laser for use in the second step include ND/YAG laser (for example, 1064 nm) or diode laser (for example, 830 nm). Laser systems suitable for CTP plate making techniques are sold on the market, and, for example, a diode laser system CDI Spark (Esko-Graphics BV.) can be used. This laser system includes: a rotary cylindrical drum that holds the film for flexographic printing plate production; an IR laser irradiation apparatus; and a layout computer, and image information is directly sent from the layout computer to the laser apparatus.

In the method for producing a flexographic printing plate according to the present embodiment, the second step may be carried out with the film for flexographic printing plate production stacked on the photosensitive resin composition layer, or it may be carried out in the preliminary stage of stacking it on the photosensitive resin composition layer.

### (Third Step)

In the third step, the photosensitive resin composition layer 4 is irradiated with an ultraviolet ray for pattern exposure using, as a mask, the ablation layer 2' on which the pattern has been drawn and processed.

At this time, the light passing through the mask promotes a curing reaction in the photosensitive resin composition layer 4, and the pattern formed in the ablation layer 2' is transferred to the photosensitive resin composition layer 4 in which the convex and concave are inverted, thereby obtaining a pattern-exposed photosensitive resin composition layer 4'. Ultraviolet ray irradiation may be performed on the whole surface or may be performed partially.

Although the film for flexographic printing plate production according to the present embodiment can be used with no particular restrictions regardless of which side faces up, from the viewpoint of mitigating the effects of refraction and scattering of ultraviolet light with which the photosensitive resin composition layer is irradiated, it is preferable to dispose the film for flexographic printing plate production so that the side of the pattern-drawn ablation layer 2' is in contact with the photosensitive resin composition layer.

Meanwhile, for purposes including protection and surface treatments for the photosensitive resin composition layer, a separate film may be established between the film for flexographic printing plate production on which the pattern has been drawn and processed and the photosensitive resin composition layer 4.

One or more intermediate layers may be further established between the photosensitive resin composition layer 4 and the ablation layer 2'. Examples of the intermediate layers include, but are not limited to, an oxygen-inhibiting layer, an adhesive layer, and a protective layer.

Hereinafter, each layer will be described.

In order to prepare printed materials with high definition and highlight areas, it is necessary to form tiny dots on the flexographic printing plate. From the viewpoint of forming such tiny dots, it is preferable that the intermediate layer is an oxygen-inhibiting layer having oxygen-inhibiting ability.

If the radical polymerization reaction when curing the photosensitive resin composition layer 4 by ultraviolet ray irradiation is suppressed by oxygen, an unreacted portion may remain in the exposed portion of the photosensitive resin composition layer 4. Since this unreacted portion is removed in the fourth step described later, the final pattern formed on the flexographic printing plate has a shape with a curved portion at the tip. This is because the portion of the photosensitive resin composition layer 4 on the ablation layer 2' side is particularly susceptible to polymerization inhibition by oxygen, and an unreacted portion tends to occur in the photosensitive resin composition layer 4 directly below the ablation layer 2'.

In contrast, if the amount of coexisting oxygen is reduced at the time of ultraviolet ray curing, the polymerization reaction is less likely to be suppressed, and the final pattern formed has a shape with a flat portion at the tip. Accordingly, when attempting to prepare a pattern with a flat portion at the tip, it is preferable that the intermediate layer has an oxygen-inhibiting ability, which can reduce oxygen in contact with the photosensitive resin composition layer 4.

Alternatively, the intermediate layer may be an adhesive layer that improves the adhesiveness between the photosensitive resin composition layer 4 and the ablation layer 2'.

Furthermore, the intermediate layer may also have a function of protecting the ablation layer 2'. In the above-described production step of a flexographic printing plate, the ablation layer 2' may be physically damaged and scratches or pinholes may occur due to contact with fingers of a worker and jigs during stacking of the photosensitive resin composition layer 4 on the film for flexographic printing plate production or during film handling.

In order to prevent such damage to the ablation layer 2', it is preferable that the intermediate layer has physical strength and heat resistance as a protective layer.

### (Fourth Step)

The fourth step is the step of removing an unexposed portion of the pattern-exposed photosensitive resin composition layer 4'.

The method for removing an unexposed portion in the fourth step (developing step) is not particularly limited, and a conventionally known method can be applied.

Specific methods include, for example, a method in which the photosensitive resin composition layer 4 is exposed and then an unexposed portion is washed away with a solvent for solvent development or a washing solution for water development, or a method in which an unexposed portion is brought into contact with a predetermined absorbing layer capable of absorbing it, and then the absorbing layer is removed to remove the unexposed portion. In a step previous to removal, the unexposed portion may be removed in advance using a spatula or a roll. If necessary, a post-exposure treatment is then performed, thereby producing a flexographic printing plate.

When an intermediate layer is located between the ablation layer 2' and the photosensitive resin composition layer 4', the intermediate layer may be removed simultaneously in the developing step.

When the photosensitive resin composition is liquid at room temperature, the above-described first to third steps shall usually include a predetermined molding step of bringing the photosensitive resin composition into a state molded into a film with a constant thickness on the support inside a dedicated apparatus (plate maker).

In the case of using the photosensitive resin composition that is liquid at room temperature as described above, the exposure step is preferably carried out by, for example, each of the following steps (A1) to (A3).

(A1) :
In the step (A1), a photosensitive resin composition layer was formed by: placing a film for flexographic printing plate production on which a mask has been formed by pattern drawing and processing on an ultraviolet transmitting glass plate (lower glass plate); pouring the photosensitive resin composition thereonto; laminating the resultant with a base film serving as a support via a spacer so as to attain a constant plate thickness; and further pressing an ultraviolet transmitting glass plate (upper glass plate) thereagainst.

In this step (A1), after placing the film for flexographic printing plate production on the lower glass plate, it is preferable to vacuum the film for the purposes of securely fixing the film for flexographic printing plate production and removing oxygen-inhibiting factors. Examples of the mechanism for vacuuming include, but are not limited to, a method in which vacuuming is performed with a pump through a groove established around the lower glass.

If the rigidity of the film for flexographic printing plate production is insufficient, the film for flexographic printing plate production wrinkles in the vacuuming step, and in severe cases, wrinkles cannot be removed and remain. The resulting wrinkles are transferred to the relief surface after curing and may significantly reduce image reproducibility. In addition, if the dimensional stability of the film for flexographic printing plate production is insufficient, the pattern drawn and processed is deformed, which is likewise a contributing factor to reduced image reproducibility.

On the other hand, in the case where the rigidity of the film for flexographic printing plate production is too high, the film cannot follow the lower glass completely at the time of vacuuming, leaving a gap and remaining air. As a result, the effect of oxygen inhibition may be increased, which may adversely affect image reproducibility. In addition, the stress caused by deformation of the highly elastic film for flexographic printing plate production may be concentrated in the ablation layer, resulting in wrinkles and pinholes. That is, it is extremely important that the film for flexographic printing plate production according to the present embodiment has rigidity in the appropriate range.

A separate film may be established between the film for flexographic printing plate production on which the pattern has been drawn and processed and the photosensitive resin composition.

In the case of preparing a flexographic printing plate (having a thickness of 4 mm or larger) for use in cardboard printing, it is preferable for supplementing the strength of a relief against a printing pressure at the time of printing to form a base shelf layer in a portion of the photosensitive resin composition layer on the upper glass plate side. In this case, the photosensitive resin composition layer is formed by sandwiching a dedicated negative film (masking film) between the upper glass plate and the base film before relief exposure.

(A2) :
In the step (A2), after the molding step of the photosensitive resin composition layer, back exposure is performed by irradiating it with active ray with an active light source such as an ultraviolet fluorescent lamp (for example, ray having a wavelength distribution at 300 nm or more) via the base film from the upper glass plate side, and thereby depositing a uniform thin cured resin layer (i.e., a floor formation layer (back deposition layer)) on the whole surface on the base film side of the plate.

In the case of establishing a masking film in the photosensitive resin composition layer formation step, a shelf layer is formed by similar exposure. In this case, the step is referred to as a masking exposure step.

The back deposition layer and the shelf layer are both formed by curing the photosensitive resin composition layer on a side opposite to the relief formation layer side of the photosensitive resin composition layer, i.e., on the support side. The photosensitive resin composition layer becomes the back deposition layer when cured on the whole surface on the support side, and becomes the shelf layer when partially cured depending on the position of the relief formation layer.

(A3) :
In the step (A3), after the back exposure step or the masking exposure step, relief forming exposure is performed by irradiating the photosensitive resin composition layer with the same active ray as in the (A2) via the film for flexographic printing plate production on which a mask has been formed by pattern drawing and processing from the lower glass side, thereby depositing an image formation layer (relief formation layer).

In the case of forming the shelf layer by the masking exposure step, a preferable form also involves removing the masking film after the relief forming exposure, and further performing a back exposure step to form a back deposition layer on the whole surface of the base film.

### (Recovery and Recycle of Photosensitive Resin Composition of Unexposed Portion)

In the method for producing a flexographic printing plate according to the present embodiment, there can be performed a recovery step of recovering the photosensitive resin composition in the unexposed portion removed in the above-described developing step as a photosensitive resin composition for the production of a new flexographic printing plate. This recovered photosensitive resin composition can be recycled as a photosensitive resin composition for the production of a new flexographic printing plate.

The recovered photosensitive resin composition may be added to an exposure machine in the production of a new flexographic printing plate. In the case of processing and molding the photosensitive resin composition before exposure, the photosensitive resin composition recovered as described above may be used in the processing and molding step.

The exposure machine to which the recovered photosensitive resin composition is added refers to an exposure machine having a unit of stacking a support and a photosensitive resin composition into layers, and the recovered photosensitive resin composition can be used when the unit is charged with the photosensitive resin composition.

Use of the recovered photosensitive resin composition permits waste reduction as well as reduction in material cost. On the other hand, if the ablation layer is eluted or migrated in a large amount into the recovered photosensitive resin composition, various inconveniences such as scattering of active ray may occur in the flexographic printing plate production step using the recovered photosensitive resin composition, and the quality of the finally obtained flexographic printing plate may be impaired.

By using the film for flexographic printing plate production according to the present embodiment, elution and migration of the ablation layer to the photosensitive resin composition layer are suppressed in the finally obtained flexographic printing plate, and thus the photosensitive resin composition with quality comparable to the unused state can be recovered at a high yield. Therefore, it is possible to maintain quality, such as improved open depth, in a new flexographic printing plate produced using the recovered photosensitive resin composition.

In detail, the method for producing a flexographic printing plate according to the present embodiment has the following effects (1) to (4).

(1) Elution and migration of the ablation layer to the resulting flexographic printing plate and original flexographic printing plate can be mitigated.
(2) By setting the base material thickness of the film for flexographic printing plate production to the appropriate range, a flexographic printing plate with excellent image reproducibility and open depth can be easily produced.
(3) In the developing step, the unexposed photosensitive resin composition with reduced deterioration and contamination can be removed and recovered. This can prevent the degradation of the photosensitive resin composition, and the photosensitive resin composition of high quality can be recycled at a high yield.
(4) In the developing step, impurities can be suppressed from being mixed into the unexposed photosensitive resin composition, allowing a wide range of developing methods to be selected.

### Examples

Hereinafter, the present embodiment will be described more specifically with reference to specific Examples and Comparative Examples, but the present invention is not limited to the following examples by any means.

### [Film for Flexographic Printing Plate Production and Production of Flexographic Printing Plate]

In Examples and Comparative Examples given below, a film for flexographic printing plate production was prepared and a flexographic printing plate was produced using the film for flexographic printing plate production.

### ((1) Production of Resin Used for Ablation Layer)

### <Production of Resin 1>

After purging the inside of a 2L separable flask polymerization vessel with nitrogen, 456.1 mL of n-hexane (dried with molecular sieves) and 656.5 mL of butyl chloride (dried with molecular sieves) are added using a syringe. After cooling the polymerization vessel by placing it in a dry ice/methanol bath at -70°C, a Teflon (R) feed tube was connected to a pressure-resistant glass liquefaction collection tube with a three-way stopcock containing 161.1 g (2871 mmol) of isobutylene monomer, and the isobutylene monomer was pumped into the polymerization vessel by nitrogen pressure. 0.647 g (2.8 mmol) of p-dicumyl chloride and 1.22 g (14 mmol) of N,N-dimethylacetamide were added. Next, 8.67 mL (79.1 mmol) of titanium tetrachloride was further added to initiate polymerization.

After performing stirring at the same temperature for 1.5 hours from the initiation of polymerization, about 1 mL of the polymerization solution was withdrawn from the polymerization solution for sampling.

Subsequently, a mixed solution of 77.9 g (748 mmol) of styrene monomer, 23.9 mL of n-hexane, and 34.3 mL of butyl chloride, which had been cooled to -70°C in advance, was added into the polymerization vessel. About 40 mL of methanol was added 45 minutes after the addition of the mixed solution to terminate the reaction, affording a reaction solution.

Solvents and other materials were distilled off from the reaction solution, which was then dissolved in toluene and washed twice with water. Furthermore, the toluene solution was added to a large amount of methanol to precipitate the polymer, and the resulting polymer was vacuum-dried at 60°C for 24 hours to obtain a resin 1.

The content proportion of styrene-derived constituent units was determined by ¹H-NMR to be 30% by mass.

### <Production of Resins 2 to 6>

The types of monomers used to form the constituent units 1 and 2 of the resin were changed as shown in Table 1 below. The other conditions were the same as for the resin 1 to obtain resins 2 to 6.

Table 1 below shows the configuration of the resins.

### <Production of Resin 7>

In a vessel with a stirrer, 2 kg of water, 65 g of tricalcium phosphate, 40 g of calcium carbonate, and 0.40 g of sodium lauryl sulfate were charged to obtain a mixed solution. Next, in a 60L reactor, 25 kg of water was charged and the temperature was raised to 80°C. Then, the mixed solution, 21.5 kg of methyl methacrylate, 110 g of lauroyl peroxide, and 430 g of 2-ethylhexyl thioglycolate were charged to the reactor. Thereafter, suspension polymerization was carried out maintaining the temperature at about 75°C. After the exothermic peak was observed, the temperature was raised to 92°C at a rate of 1°C/min. After aging for 60 minutes, the polymerization reaction was substantially terminated.

Next, the polymerization reaction solution was cooled to 50°C, and 20 mass% sulfuric acid was charged to dissolve the suspending agent. The polymerization reaction solution was then passed through a 1.68-mm mesh sieve to remove agglomerates, and the resulting bead-like polymer was subjected to a washing, dehydration, and drying treatment to obtain a resin 7.

### <Resin 8 and Resin 9>

TUFPRENE 315 (manufactured by Asahi Kasei Corporation, styrene-butadiene block copolymer) was used as a resin 8.

Miractran E394POTA (manufactured by Tosoh Corporation, thermoplastic polyurethane elastomer) was used as a resin 9.

Table 1 below shows the resins 1 to 9 to be contained in the ablation layer (sometimes denoted as ablation layer-contained resins).

**[Table 1]**

| No. | Resin | Constituent unit (1) | | | | | Constituent unit (2) |
|---|---|---|---|---|---|---|---|
| | | Monomer | R1 | R2 | R3 | R4 | Monomer |
| 1 | Resin 1 | Isobutylene | -CH3 | -CH3 | -H | -H | Styrene |
| 2 | Resin 2 | 2-Methyl-1-butene | -CH2CH3 | -CH3 | -H | -H | Styrene |
| 3 | Resin 3 | 2-Methyl-2-butene | -CH3 | -CH3 | -CH3 | -H | Styrene |
| 4 | Resin 4 | 2,3-Dimethyl-2-butene | -CH3 | -CH3 | -CH3 | -CH3 | Styrene |
| 5 | Resin 5 | Isobutylene | -CH3 | -CH3 | -H | -H | α-Methylstyrene |
| 6 | Resin 6 | Isobutylene | -CH3 | -CH3 | -H | -H | - |
| 7 | Resin 7 | Methyl methacrylate | -COOCH3 | -CH3 | -H | -H | - |
| 8 | TUFPRENE 315 | - | - | - | - | - | - |
| 9 | Miractran E394POTA | - | - | - | - | - | - |

### ((2) Production of Film for Flexographic Printing Plate Production)

### <Production of Film for Flexographic Printing Plate Production of Example 1>

6.5 parts by mass of the resin 1, 54.0 parts by mass of toluene, and 36.0 parts by mass of cyclohexanone were mixed, and the resin 1 was dissolved in the solvent.

Thereafter, 3.5 parts by mass of carbon black (manufactured by Mitsubishi Chemical Corporation, #1000) was further charged, and the mixture was then mixed for 4 hours using a bead mill to obtain a carbon black dispersion.

A base material 1 shown in Table 2 below was coated with the carbon black dispersion obtained as described above so that the film thickness after drying was 2.5 µm. A drying treatment at 90°C for 2 minutes was performed to obtain a film for flexographic printing plate production, which was a stack of the ablation layer and the base material.

### <Production of Film for Flexographic Printing Plate Production of Comparative Example 2>

7.8 parts by mass of the resin 8: TUFPRENE 315 (manufactured by Asahi Kasei Corporation, styrene-butadiene block copolymer), 70.4 parts by mass of toluene, and 17.6 parts by mass of propylene glycol 1-monomethyl ether 2-acetate (PMA) were mixed to dissolve TUFPRENE 315 in the solvent. Thereafter, carbon black (manufactured by Mitsubishi Chemical Corporation, MCF-88) was further charged, and the mixture was then mixed for 4 hours using a bead mill to obtain a carbon black dispersion.

Except that the carbon black dispersion obtained as described above was used, a film for flexographic printing plate production was obtained using the base material 1 shown in Table 2 below, in the same manner as for the film for flexographic printing plate production of Example 1.

### <Production of Film for Flexographic Printing Plate Production of Comparative Example 3>

7.8 parts by mass of the resin 9: Miractran E394POTA (manufactured by Tosoh Corporation, thermoplastic polyurethane elastomer), 44.0 parts by mass of toluene, and 44.0 parts by mass of 2-propanol were mixed, and the polyamide was dissolved in the solvent. Thereafter, carbon black (manufactured by Mitsubishi Chemical Corporation, MCF-88) was further charged, and the mixture was then mixed for 4 hours using a bead mill to obtain a carbon black dispersion.

Except that the carbon black dispersion obtained as described above was used, a film for flexographic printing plate production was obtained using the base material 1 shown in Table 2 below, in the same manner as for the film for flexographic printing plate production of Example 1.

### <Production of Films for Flexographic Printing Plate Production of Examples 2 to 14 and Comparative Examples 1, 4 to 6>

The resins and base materials to be used were changed in combinations from Table 1 and Table 2, respectively. The other conditions were the same as for the film for flexographic printing plate production of Example 1 to obtain various types of films for flexographic printing plate production.

In Table 2 below, PP stands for polypropylene and PET stands for polyethylene terephthalate.

**[Table 2]**

| Base material No. | Thickness (um) | Base material | Product name | Manufacturer or distributor |
|---|---|---|---|---|
| 1 | 50 | PP | PYLEN P3162 | Toyobo Co., Ltd. |
| 2 | 6 | PP | 3399N015 | Rigaku Corporation |
| 3 | 12 | PP | 3399N023 | Rigaku Corporation |
| 4 | 20 | PP | CF-86 | Asahi Kasei Corporation |
| 5 | 25 | Nylon | Supernyl | Mitsubishi Chemical Corporation |
| 6 | 50 | PET | DIAFOIL | Mitsubishi Chemical Corporation |
| 7 | 50 | PE | PE3K-BT | Futamura Chemical Co., Ltd. |
| 8 | 65 | PP | SOP Grade orphan polypropylene film | OJK, K.K. |
| 9 | 80 | PP | SOP Grade orphan polypropylene film | OJK, K.K. |
| 10 | 125 | PET | DIAFOIL | Mitsubishi Chemical Corporation |
| 11 | 188 | PET | DIAFOIL | Mitsubishi Chemical Corporation |

### ((3) Production of Photosensitive Resin Composition)

### <(Production Example) Production of Unsaturated Prepolymer Composition>

An unsaturated prepolymer composition used in a photosensitive resin composition was produced as described below.

1200 g of poly(3-methyl-1,5-pentanediol adipate) diol ("Kurapol P3010" manufactured by Kuraray Co., Ltd.) and 800 g of polyoxyethylene (EO)-oxypropylene (PO) block copolymer diol ("SUNNIX PL2100" manufactured by Sanyo Chemical Industries, Ltd.) as diols, and 0.03 g of dibutyltin dilaurate were added, and stirred at 40°C until homogeneous to obtain a mixture.

To the obtained mixture, 137 g of tolylene diisocyanate ("CORONATE T80" manufactured by Tosoh Corporation) was added, and stirred until homogeneous to obtain a mixture.

After becoming homogeneous, the mixture was heated to 80°C and then reacted for 4 to 5 hours to prepare a prepolymer precursor having isocyanate groups at both ends.

To the obtained prepolymer precursor, 387 g of poly(oxypropylene) glycol monomethacrylate ("Blemmer PP" manufactured by NOF Corporation) was added as a (meth)acrylating agent and reacted for 2 hours to obtain a reaction product.

A portion of the obtained reaction product was isolated and subjected to IR spectrometry to confirm the disappearance of the isocyanate groups.

As described above, an unsaturated prepolymer composition was obtained.

GPC measurement was performed on the unsaturated prepolymer composition. The number average molecular weight of the high molecular weight material derived from the unsaturated prepolymer component in the unsaturated prepolymer composition was 22500.

### <Preparation of Photosensitive Resin Composition a>

To 68.2 parts by mass of the unsaturated prepolymer composition obtained in the above-described Production Example, 21.8 parts by mass of diethylene glycol (2-ethylhexyl) ether acrylate ("ARONIX M-120" manufactured by Toagosei Co., Ltd.), 1.1 parts by mass of trimethylolpropane trimethacrylate ("NK Ester TMPT" manufactured by Shin-Nakamura Chemical Co., Ltd.), 6.3 parts by mass of dibutyl sebacate ("DBS" manufactured by Hokoku Corporation), 1.0 parts by mass of 2,2-dimethoxy-2-phenylacetophenone ("IRGACURE 651" manufactured by Ciba Specialty Chemicals) as a photopolymerization initiator, and 1.6 parts by mass of 2,6-di-t-butyl-p-cresol ("IONOL" manufactured by Oxalis Chemicals Ltd.) as an antioxidant were added, and the mixture was stirred and mixed in a heated state at 60°C to obtain a photosensitive resin composition a.

### <Preparation of Photosensitive Resin Composition b>

A photosensitive resin composition b was obtained in the same manner as for the photosensitive resin composition a, except that a liquid polybutadiene ("LBR-305" manufactured by Kuraray Co., Ltd.) was used instead of the above-described unsaturated prepolymer composition of Production Example.

Using the obtained photosensitive resin compositions and films for flexographic printing plate production, flexographic printing plates were prepared through a laser drawing step, a molding and exposure step, a developing step, a post-exposure step, and a drying step sequentially, as shown in (4) to (8) below.

### ((4) Laser Drawing on Film for Flexographic Printing Plate Production)

The film for flexographic printing plate production was placed on Esko CDI SPARK 2530, and laser drawing was performed on the ablation layer using a test image with the image pattern described later at a resolution of 8000 dpi and a laser intensity of 3.0 J.

### ((5) Molding and Exposure Step)

Molding and Exposure were performed by (A1) to (A3) using the "ALF-213E plate maker" manufactured by Asahi Kasei Corporation.
(A1) :
   The film for flexographic printing plate production after image drawing was placed on an ultraviolet transmitting lower glass plate so that the ablation layer after image drawing was positioned on the opposite side of the lower glass plate with the base material in between, and then the film for flexographic printing plate production was fixed by vacuuming with a pump through a groove established around the lower glass. A photosensitive resin composition layer was formed by pouring the photosensitive resin composition thereonto, laminating the resultant with a base film serving as a support via a spacer so as to attain a constant plate thickness, and further pressing an ultraviolet transmitting glass plate (upper glass plate) thereagainst. The photosensitive resin composition layer was formed by sandwiching a dedicated masking film between the upper glass plate and the base film before relief exposure.
(A2) :
   The photosensitive resin composition layer thus formed was irradiated with active ray with an active light source such as an ultraviolet fluorescent lamp (ray having a wavelength distribution at 300 nm or more) via the base film from the upper glass plate side.

Since the masking film was established in the photosensitive resin composition layer formation step, masking exposure was made by the same exposure to form a shelf layer.

(A3) :
After the masking exposure step, there was performed a relief forming exposure step of irradiating the photosensitive resin composition layer with the same active ray as in the upper glass plate side via the film for flexographic printing plate production after image drawing from the lower glass side to perform image formation, thereby obtaining an original flexographic printing plate.

As described above, the photosensitive resin composition layer was formed in (A1).

Here, the test image and masking film used were provided with a design for forming a 300 mm × 500 mm shelf layer and a 500 µm wide linear unexposed portion (hereinafter, referred to as "open" or an "open line") within a 200 mm × 250 mm solid image.

Subsequently, the photosensitive resin composition layer was exposed in (A2) and (A3) to obtain an original flexographic printing plate having a plate thickness of 3 mm and a relief depth of 2 mm. In this context, the relief depth is a conventional term that expresses a length determined by subtracting the height of the shelf layer from a plate thickness, i.e., the depth of a printed image relief.

The dose of masking exposure was appropriately adjusted in order to adjust the relief depth.

Relief formation was performed under the condition that the dose of relief exposure was set to 600 mJ/cm².

### ((6) Developing Step)

The film for flexographic printing plate production after image drawing was peeled off from the original flexographic printing plate, and the unexposed photosensitive resin composition was collected and removed from the original flexographic printing plate using a rubber spatula. Thereafter, the development was performed under conditions involving a liquid temperature of 40°C and a development time of 10 minutes, using "AL-400W developing machine" manufactured by Asahi Kasei Corporation (a drum rotary spray system, the number of drum rotations: 20 rpm/minute, spray pressure: 0.15 Pa) and using, as the developing solution, an aqueous solution containing 2% by mass of "APR(R) washing agent type W-10" (main agent: anionic surfactant) manufactured by Asahi Kasei Corporation which is capable of emulsifying the photosensitive resin composition, 0.5% by mass of "APR(R) surface treatment agent type A-10" (main agent: nonionic surfactant, benzophenone) manufactured by Asahi Kasei Corporation, and 0.3% by mass of "antifoaming agent SH-4" (silicone mixture) manufactured by Asahi Kasei Corporation.

The plate thus developed was washed to the extent that foam from the developing solution was rinsed off with tap water.

### ((7) Post Exposure Step)

Post exposure was performed by an in-water exposure scheme using "AL-200UP post exposure machine" manufactured by Asahi Kasei Corporation which has both an ultraviolet fluorescent lamp and a germicidal lamp.

The exposure was performed for an exposure time such that the dose of irradiation from each light source was 2000 mJ/cm² (ultraviolet fluorescent lamp) and 2000 mJ/cm² (germicidal lamp) on the surface of the photosensitive resin composition.

### ((8) Drying Step)

The plate thus post-exposed was dried for about 30 minutes using "ALF-DRYER" manufactured by Asahi Kasei Corporation until water disappeared from the surface to obtain a flexographic printing plate.

### [Evaluation of Flexographic Printing Plate]

### <Evaluation of Ablation Layer Elutability>

For the unexposed photosensitive resin composition recovered in the above-described developing step, the elutability of the ablation layer was evaluated as described below.

1 L of the unexposed photosensitive resin composition was filtered through wire meshes with various openings, and the opening through which the ablation layer eluted into the photosensitive resin composition passed without being removed was evaluated.

A smaller opening through which the eluted ablation layer passed was considered to indicate that it had a smaller mass and particle size and was less elutable.

In the following evaluation criteria, a sample given a score of A to D was evaluated as being practically usable without any problem.

### (Evaluation Criteria)

A: No elution
B: Passing through a wire mesh with an opening of less than 0.077 mm (200 mesh)
C: Passing through a wire mesh with an opening of 0.077 to less than 0.251 mm (65 mesh)
D: Passing through a wire mesh with an opening of 0.251 to less than 0.455 mm (40 mesh)
E: Passing through a wire mesh with an opening of 0.455 mm or more

### <Evaluation of Open Depth (Residue)>

The groove shape of the 500 µm wide open line was observed using µDEPTH & HEIGHT MEASURING SCOPE KY-90 (manufactured by Nisshooptical Co., Ltd.), and the depth of the groove was measured.

Evaluation criteria for the measurement results are shown below.

In the following evaluation criteria, a sample given a score of A to D was evaluated as being practically usable without any problem.

### (Evaluation Criteria)

A: A depth of 151 µm or larger
B: A depth of 121 µm or more and less than 151 µm
C: A depth of 91 µm or more and less than 121 µm
D: A depth of 70 µm or more and less than 91 µm
E: A depth of less than 70 µm

### <Evaluation of Film Rigidity>

The workability at the time of vacuuming was evaluated. The ablation layer-stacked film after image drawing was placed on the lower glass, air was extracted with a roller while vacuuming from a groove around the lower glass, and the appearance of the film after the work was evaluated as described below.
Here, the dimensions of the film were 500 mm × 730 mm, and the portion up to 50 mm inside the side was defined as "edge".

### (Evaluation Criteria)

A: No wrinkles occur.
B: Removable wrinkles occur.
C: Removable wrinkles occur on the whole surface.
D: Unremovable wrinkles or scratches occur only at the edge.
E: Unremovable wrinkles or scratches occur on the whole surface. Alternatively, air remains.

The results of various evaluations are shown in Table 3 and Table 4.

**[Table 3]**

| No. | Example | Example | Example | Example | Example | Example | Example | Example | Example | Example | Example | Example | Example | Example |
|---|---|---|---|---|---|---|---|---|---|---|---|---|---|---|
| | 1 | 2 | 3 | 4 | 5 | 6 | 7 | 8 | 9 | 10 | 11 | 12 | 13 | 14 |
| Base material | 1 | 1 | 1 | 1 | 3 | 4 | 5 | 6 | 7 | 8 | 9 | 1 | 1 | 1 |
| Ablation layer-contained resin | 1 | 2 | 3 | 4 | 1 | 1 | 1 | 1 | 1 | 1 | 1 | 5 | 6 | 1 |
| Photosensitive resin composition | a | a | a | a | a | a | a | a | a | a | a | a | a | b |
| Ablation layer elutability | A | A | A | A | A | A | B | A | A | A | A | A | B | B |
| Open depth | A | A | A | A | A | A | B | B | A | A | A | A | A | C |
| Film rigidity | A | A | A | A | C | B | B | A | A | A | B | A | B | A |

**[Table 4]**

| No. | Comparative Example | Comparative Example | Comparative Example | Comparative Example | Comparative Example | Comparative Example |
|---|---|---|---|---|---|---|
| | 1 | 2 | 3 | 4 | 5 | 6 |
| Base material | 1 | 1 | 1 | 2 | 10 | 11 |
| Ablation layer-contained resin | 7 | 8 | 9 | 1 | 1 | 1 |
| Photosensitive resin composition | a | a | a | a | a | a |
| Ablation layer elutability | E | A | E | A | A | A |
| Open depth | C | E | E | D | D | E |
| Film rigidity | C | D | A | E | E | E |

### <Evaluation of Flexographic Printing Plate Obtained Using Recovered Photosensitive Resin Composition and Photosensitive Resin Composition in Unexposed Portion>

Under the conditions described in Example 1, the unexposed photosensitive resin composition recovered in the above-described step was used again to produce a flexographic printing plate by the same steps.

Using the produced flexographic printing plate and the recovered unexposed photosensitive resin composition, the above-described evaluations were performed to evaluate the effect of the ablation layer eluted into the recovered unexposed photosensitive resin composition on the flexographic printing plate obtained when reused and the recovered photosensitive resin composition.

The evaluation results are shown in Table 5.

Example 1' in Table 5 is an example where utilizing the photosensitive resin composition in the unexposed portion recovered in the production step of a flexographic printing plate in Example 1 as the photosensitive resin composition in the production step of a flexographic printing plate in Example 1 again is regarded as one cycle, and this cycle is performed five times.

Comparative Example 1 is an example where a film for flexographic printing plate production having an ablation layer containing the resin 7 instead of the resin 1 was used in the production step of a flexographic printing plate in Example 1.

Furthermore, Comparative Example 1' is an example where a film for flexographic printing plate production having an ablation layer containing the resin 7 instead of the resin 1 was used in the production step of a flexographic printing plate in Example 1, and utilizing the recovered unexposed photosensitive resin composition as the photosensitive resin composition in the production step of a flexographic printing plate again is regarded as one cycle, and this cycle is performed five times.

**[Table 5]**

| No. | Example | Example | Comparative Example | Comparative Example |
|---|---|---|---|---|
| | 1 | 1' | 1 | 1' |
| Base material | 1 | 1 | 1 | 1 |
| Ablation layer-contained resin | 1 | 1 | 7 | 7 |
| Cycle (times) | 0 | 5 | 0 | 5 |
| Ablation layer elution | A | A | E | E |
| Open depth | A | A | C | E |
| Film rigidity | A | A | C | D |

As shown in Table 5, it was found that the evaluation of the elutability of the ablation layer was superior in Example 1' compared to Comparative Example 1', and the evaluation of the prepared flexographic printing plate was also superior.

The present application is based on Japanese Patent Application No. 2022-108488 filed with the Japan Patent Office on July 5, 2022, the contents of which are incorporated herein by reference.

### Industrial Applicability

The film for flexographic printing plate production, and the method for producing a flexographic printing plate according to the present invention has industrial applicability in wide general commercial printing fields.

### Reference Signs List

1 base material
2 ablation layer
2' pattern-drawn ablation layer
3 substrate
4 photosensitive resin composition layer
4' pattern-exposed photosensitive resin composition layer

## Claims

1. A film for flexographic printing plate production, comprising:
a base material; and
an ablation layer stacked on the base material, wherein
the ablation layer comprises a resin having a constituent unit (1) represented by the following general formula (1), and
the base material has a thickness of 10 µm or more and less than 100 µm: 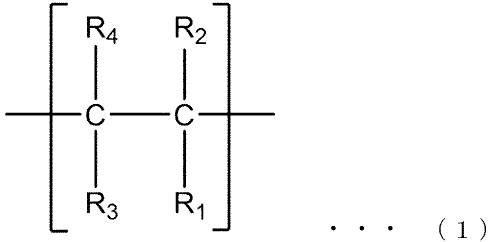 wherein, in the formula (1), R₁ and R₂ each independently represent a non-polar group, and R₃ and R₄ each independently represent a hydrogen atom or a non-polar group.

2. The film for flexographic printing plate production according to claim 1, wherein
in the formula (1), R₁ and R₂ are each independently any one selected from the group consisting of an alkyl group, an alkenyl group, and an alkynyl group, and
R₃ and R₄ are each independently any one selected from the group consisting of a hydrogen atom, an alkyl group, an alkenyl group, and an alkynyl group.

3. The film for flexographic printing plate production according to claim 1, wherein
in the formula (1), R₁ and R₂ are each independently an alkyl group, and
R₃ and R₄ are each independently a hydrogen atom or an alkyl group.

4. The film for flexographic printing plate production according to claim 1, wherein
the resin further comprises a constituent unit (2) derived from a monovinyl-substituted aromatic hydrocarbon.

5. The film for flexographic printing plate production according to claim 1, wherein
the base material comprises a resin having a polyester or polyolefin skeleton.

6. The film for flexographic printing plate production according to claim 1, wherein
the base material is made of a resin having a polyester or polyolefin skeleton.

7. The film for flexographic printing plate production according to claim 1, wherein
the base material is made of a resin having a polyolefin skeleton.

8. A stack comprising:
an original flexographic printing plate having a photosensitive resin composition layer; and
the film for flexographic printing plate production according to any one of claims 1 to 7 on the original flexographic printing plate.

9. A method for producing a flexographic printing plate using the stack according to claim 8, comprising:
a drawing step of irradiating the film for flexographic printing plate production with an infrared ray to draw and process a pattern;
an exposure step of irradiating the photosensitive resin composition layer with an ultraviolet ray to form a pattern using, as a mask, the ablation layer on which the pattern has been drawn and processed in the drawing step; and
a developing step of removing an unexposed portion of the photosensitive resin composition layer.

10. The method for producing a flexographic printing plate according to claim 9, wherein
the photosensitive resin composition comprises a polymer having a carbonyl group.

11. The method for producing a flexographic printing plate according to claim 9, wherein
the base material of the film for flexographic printing plate production is made of a resin having a polyester or polyolefin skeleton.

12. The method for producing a flexographic printing plate according to claim 9, wherein the base material of the film for flexographic printing plate production is made of a resin having a polyolefin skeleton.

13. The method for producing a flexographic printing plate according to claim 9, further comprising:
a recovery step of recovering the unexposed portion removed in the developing step, for use in production of a new original flexographic printing plate.
